Europäisches Patentamt

**European Patent Office**

Office européen des brevets

(11) Publication number: **0 345 058**
**A2**

(12) **EUROPEAN PATENT APPLICATION**

(21) Application number: **89305519.4**

(22) Date of filing: **01.06.89**

(51) Int. Cl.⁴: **G 11 C 11/00**

(30) Priority: **02.06.88 JP 135920/88**

(43) Date of publication of application:
**06.12.89  Bulletin  89/49**

(84) Designated Contracting States: **DE FR GB**

(71) Applicant: **SEIKO INSTRUMENTS INC.**
**31-1, Kameido 6-chome Koto-ku**
**Tokyo 136  (JP)**

(72) Inventor: **Takada, Ryoji c/o Seiko Instruments Inc.**
**31-1 Kameido 6-chome Koto-ku**
**Tokyo  (JP)**

(74) Representative: **Caro, William Egerton et al**
**J. MILLER & CO. Lincoln House 296-302 High Holborn**
**London WC1V 7JH  (GB)**

(54) **Non-volatile static RAM circuit.**

㊐ A memory cell arranged to operate during normal operation as a static random access memory for storing bit data and provided with self back-up during interruption of power comprises a first inverter (5, 7) and a second inverter (2, 6) coupled together to form a flip-flop effective for storing bit data. The first inverter comprises a memory element (7) switchable between a normal transistor function and a non-volatile memory function. The memory element is selectively controlled during normal operation to provide the normal transistor function for enabling the flip-flop to serve as the static random access memory, immediately before interruption of power to receive the stored bit data to reserve the same in non-volatile state, and to restore the reserved bit data in the flip-flop serving as the static random access memory when power is recovered.

FIG. 1

EP 0 345 058 A2

## Description

## NON-VOLATILE STATIC RAM CIRCUIT

The present invention relates to a non-volatile static RAM circuit for use in an electronic device such as an electronic computer, a communication device or a programmable controller.

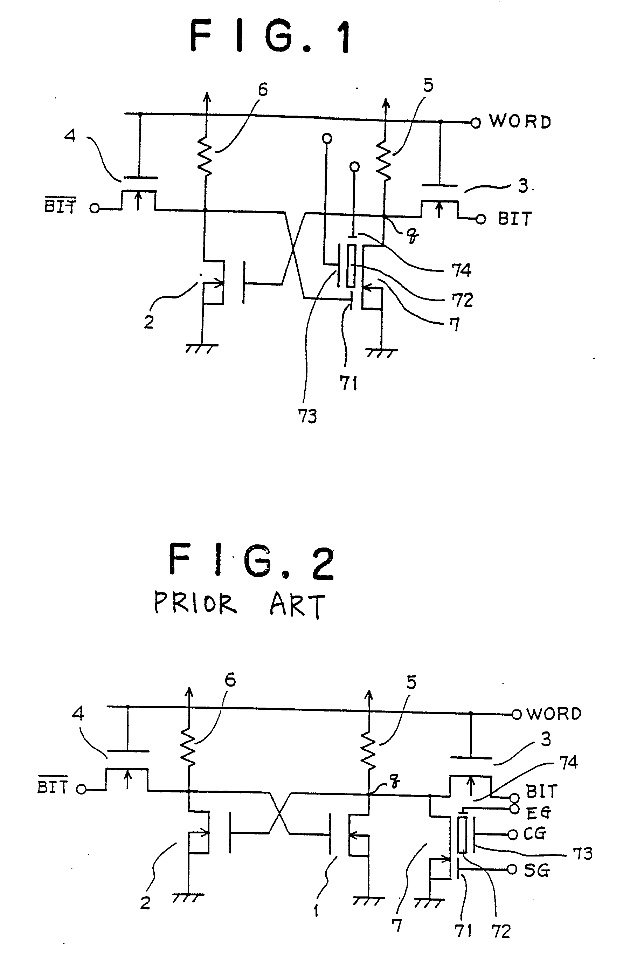

A conventional non-volatile static RAM circuit is shown in Figure 2. The conventional circuit comprises a static random access memory element (hereinafter referred to as an "SRAM") and an electrically erasable programmable read only memory element 7 (hereinafter referred to as an "EEPROM") for back-up of the SRAM. The SRAM comprises a first inverter composed of an n-channel MOS transistor 1 and a load resistor 5, and a second inverter composed of another n-channel MOS transistor 2 and a load resistor 6. The input and output terminals of the first and second inverters are mutually inter-connected to constitute a flip-flop. A pair of n-channel transistors 3 and 4, each having a gate electrode connected to a word line, are coupled to both sides of the flip-flop to drive the SRAM thereby to store data. The EEPROM 7 has a drain electrode connected to an output node $q$ of the SRAM, and comprises a selecting or switching gate 71, a floating gate 72, a control gate 73 and an erasing gate 74. The operation of reserving data stored in the SRAM to the EEPROM 7 is carried out by the steps of weakly biasing the selecting gate 71 in the inverse direction, and applying to the control gate 73 a voltage effective strongly to cause inversion in a channel region under the floating gate 72 to produce a surface potential difference to generate hot electrons in this region so as to inject the hot electrons into the floating gate 72. The operation of erasing the EEPROM 7 is carried out by the steps of setting the control gate 73 to ground potential, and applying to the erasing gate 74 a voltage of 15 to 20 volts effective to extract the electrons from the floating gate 72 in the form of Fowler-Nordheim tunnel current. Accordingly, the SRAM and EEPROM are connected to each other simply at their common input and output terminals, while the SRAM functions to effect its writing/reading operation and the EEPROM functions to effect its back-up or reserving operation separately and independently from each other.

A disadvantage of such a conventional memory circuit is that it needs at least four MOS transistors and one EEPROM element and so considerable space is required for electrical connections, which increases the unit cell area.

The present invention seeks to provide a simplified non-volatile static RAM circuit having a smaller number of components than the conventional memory circuit.

According to the present invention, there is provided a memory cell normally operable as a static random access memory for storing bit data and provided with self back-up during interruption of power, comprising first and second inverters coupled together to define a flip-flop for storing bit data, and writing and reading means coupled to the flip-flop so as to effect writing and reading of bit data to and from the flip-flop, characterised in that the first inverter comprises a memory element which is switchable between a normal transistor function and a non-volatile memory function.

As described below, the memory element comprises a MOS memory element having a floating gate effective to reserve the bit data, and a control gate effective to control the potential level of the floating gate and arranged selectively to receive a first bias voltage (2 to 4 volts) for causing the memory element to provide the normal transistor function to enable the flip-flop to serve as the static random access memory, a second bias voltage (8 to 12 volts) immediately before interruption of power for causing the memory element to receive the stored bit data to reserve the same in non-volatile state, and a third bias voltage (0 volts) for causing the memory element to restore the reserved bit data in the flip-flop serving as the static random access memory.

This allows one MOS transistor to be eliminated from the circuit by comparison with the prior art.

The invention will be described further, by way of example, with reference to the accompanying drawings, in which:-

Figure 1 is a circuit diagram showing a non-volatile static RAM circuit according to the invention; and

Figure 2 is a circuit diagram showing the conventional non-volatile static RAM circuit.

One embodiment of non-volatile static RAM circuit or cell according to the present invention is shown in Figure 1. The circuit comprises a flip-flop for storing bit data, the flip-flop having a pair of first and second inverters which are mutually inter-connected such that an input terminal of one inverter is coupled to an output terminal of the other inverter. The first inverter comprises a series connected load resistor 5 and EEPROM element 7. The EEPROM element 7 has a drain electrode connected to the resistor 5 to define an output terminal or node $q$, a source electrode connected to ground, and a selecting or switching gate 71 arranged to define the input terminal of the first inverter such that the EEPROM element 7 functions as a MOS transistor having a channel region between the drain and source electrodes and further having the switching gate 71 disposed over a part of the channel region to control the conductivity thereof according to a bias voltage applied to the switching gate 71. The EEPROM 7 also has a floating gate 72 disposed over the remaining part of the channel region for reserving bit data in the form of electrons injected thereto, a control gate 73 disposed on the floating gate for controlling the potential level of the floating gate to select the function of the EEPROM 7, and an erasing gate 74.

The second inverter comprises a series connection of a load resistor 6 and MOS transistor 2, the MOS transistor 2 having a source electrode connected to ground and a drain electrode connected to the resistor 6 and to the switching gate 71 of the EEPROM 7. Further, a pair of n-channel driving transistors 3 and 4 are connected to the flip-flop to effect the reading and writing of bit data. The transistor 3 has a channel connected to the node q and a gate connected to a word line. The transistor 4 has a channel connected to the junction between the resistor 6 and the MOS transistor 2 and a gate connected to the same word line.

In operation, the circuit normally functions as an SRAM cell while the power is supplied thereto. Immediately before the power supply is cut off, the circuit is switched to function as a non-volatile memory cell such that the bit data is transferred to the floating gate 72 of the EEPROM 7 to effect a reserving operation. When the power supply is recovered, the bit data reserved in the EEPROM 7 is transferred back to the SRAM memory to effect a recalling or restoring operation. These operations are controlled by the control gate 73 capacitively coupled to the floating gate 72.

During normal operation as the SRAM, the control gate 73 is supplied with a bias voltage of 2 to 4 volts effective to cause inversion in the channel region under the floating gate 72 even when the electrons have been injected into the floating gate 72. By such biasing of the control gate 73, the EEPROM 7 can function as an n-channel MOS transistor having the switching or selecting gate 71 to constitute the first inverter of the flip-flop together with the load resistor 5.

During the reserving operation, the control gate 73 is biased with a voltage of 8 to 12 volts. When the output node q of the SRAM is held at an "H" level, the power supply voltage is applied to the drain of the EEPROM 7 such that electrons are injected into the floating gate 72 to effect the transfer of bit data from the SRAM to the EEPROM. At this time, the selecting gate 71 is held at an "L" level, because it is connected to the output node of the second inverter. However, the load resistor 6 and the n-channel MOS transistor 2 of the second inverter are suitably set so as to maintain the voltage of the selecting gate 71 substantially equal to the threshold voltage thereof thereby to enable the reserving operation to take place. On the other hand, when the output node q of the SRAM is held at an "L" level, the drain voltage of the EEPROM 7 is held low so that hot electrons are not generated and therefore injection of electrons does not occur into the floating gate 72.

During the recalling or restoring operation, the control gate 73 is connected to ground and the power supply voltage is applied to the circuit. When electrons are stored in the floating gate 72, the channel region of the EEPROM 7 is turned off so that the output node q is set to an "H" level as before interruption of the power supply. When electrons are not stored in the floating gate, the channel region of the EEPROM 7 is turned on so that the output node is set to an "L" level as before interruption of the power supply.

As described above, according to the present invention, a non-volatile SRAM circuit may comprise three MOS transistors and one EEPROM element, thereby reducing the unit cell area and eliminating the bias circuit for the selecting gate of the EEPROM needed in the conventional non-volatile SRAM circuit. Further, in the described embodiment of the present invention, the selecting gate of the EEPROM has an internal connection within the memory circuit eliminating the external connection of the conventional circuit and thereby reducing the cell area.

## Claims

1. A memory cell normally operable as a static random access memory for storing bit data and provided with self back-up during interruption of power, comprising first and second inverters (2, 7) coupled together to define a flip-flop for storing bit data, and writing and reading means (3, 4) coupled to the flip-flop so as to effect writing and reading of bit data to and from the flip-flop, characterised in that the first inverter comprises a memory element (7) which is switchable between a normal transistor function and a non-volatile memory function.

2. A memory cell according to claim 1, characterised in that the memory element is arranged during normal operation to provide the normal transistor function whereby to enable the flip-flop to serve as a static random access memory, is arranged immediately before interruption of power to receive the stored bit data to reserve the same in non-volatile state, and is arranged when power is recovered to transfer the reserved bit data for restoring the bit data in the flip-flop serving as the static random access memory.

3. A memory cell according to claim 1 or 2, characterised in that the memory element comprises a MOS memory element having a floating gate (72) effective to reserve the stored bit data, and a control gate (73) effective to control the potential level of the floating gate for selectively determining the state of the memory element.

4. A memory cell according to claim 3, characterised in that the control gate is arranged to receive three different bias voltages for selectively determining the state of the memory element.

5. A memory cell according to any preceding claim characterised in that the memory element is operable by a power supply below 5 volts.

6. A memory cell according to any preceding claim characterised by control means operable to control the memory element.

7. A memory cell according to any preceding claim characterised in that the first inverter further comprises a load (5) connected in series with the memory element.

8. A memory cell according to any preceding claim characterised in that the second inverter comprises a transistor (2) and a load (6) connected in series.

9. A memory cell according to any preceding claim characterised in that the writing and reading means comprise first and second transistors (3, 4) connected respectively to the first and second inverters.

# F I G. 1

# F I G. 2
## PRIOR ART